(19) Europäisches Patentamt
European Patent Office
Office européen des brevets

(11) **EP 0 517 218 B1**

(12) **FASCICULE DE BREVET EUROPEEN**

(45) Date de publication et mention
de la délivrance du brevet:
**26.11.1997 Bulletin 1997/48**

(51) Int Cl.6: **H03H 17/02**, H03H 17/06

(21) Numéro de dépôt: **92109461.1**

(22) Date de dépôt: **04.06.1992**

(54) **Procédé de filtrage numérique haut débit et dispositif de mise en oeuvre de ce procédé**

Digitales Filterverfahren mit hoher Geschwindigkeit und Anordnung zur Ausführung dieses Verfahrens

High throughput digital filtering process and device for performing this process

(84) Etats contractants désignés:
**CH DE ES FR GB IT LI**

(30) Priorité: **07.06.1991 FR 9106936**

(43) Date de publication de la demande:
**09.12.1992 Bulletin 1992/50**

(73) Titulaires:
• **ALCATEL ESPACE**
  **F-92407 Courbevoie Cédex (FR)**
  Etats contractants désignés:
  **DE ES FR GB IT**
• **ALCATEL N.V.**
  **NL-1077 XX Amsterdam (NL)**
  Etats contractants désignés:
  **CH LI**

(72) Inventeurs:
• **Belis, Eric**
  **F-31100 Toulouse (FR)**
• **Rousset, Daniel**
  **F-31200 Toulouse (FR)**
• **Marguinaud, André**
  **F-91120 Palaiseau (FR)**

• **Gayrard, Jean-Didier**
  **F-31400 Toulouse (FR)**

(74) Mandataire: **Smith, Bradford Lee et al**
  **ALCATEL ALSTHOM,**
  **Département de Propriété Industrielle,**
  **30, avenue Kléber**
  **75116 Paris (FR)**

(56) Documents cités:
• **PHILIPS JOURNAL OF RESEARCH vol. 30, no. 1, Février 1975, EINDHOVEN NL pages 73 - 84 T.A.CLAASEN 'SOME CONSIDERATIONS ON THE IMPLEMENTATION OF DIGITAL SYSTEMS FOR SIGNAL PROCESSING'**
• **IEEE ACOUSTICS, SPEECH, AND SIGNAL PROCESSING MAGAZINE vol. 25, no. 3, Juin 1977, NEW YORK US pages 256 - 257 GENYA KISHI E.A. 'A NEW REALIZATION SCHEME OF DIGITAL FILTERS-ROW-WISE ADDITION CONFIGURATION'**
• **TECHNISCHE RUNDSCHAU vol. 81, no. 25, 23 Juin 1989, BERN CH pages 52 - 55 DANIEL L]THI 'HOCHLEISTUNGS-DS-PROZESSOREN IN ASIC'**

# Description

L'invention concerne un procédé de filtrage numérique haut-débit et un dispositif de mise en oeuvre de ce procédé.

L'invention a pour objet de réaliser un dispositif de filtrage numérique paramétrable et modulaire, adapté à une implantation dans des circuits de conception à la demande, par exemple de type "ASIC" (Circuit Intégré à Application Spécifique), sur une largeur de bande d'entrée de plusieurs mégahertz (par exemple 6 MHz) avec une caractéristique de filtrage performante. Ce dispositif doit être programmable en nature (passe-bas, passe-haut, passe-bande, coupe-bande ou multi-bandes), en bande passante, en bande de transition et en fréquence centrale. De plus ce dispositif doit satisfaire aux exigences du domaine spatial relatives notamment à : la fiabilité; l'optimisation de la consommation; l'encombrement; la sensibilité aux radiations.

Pour réaliser un tel dispositif deux approches sont envisageables :

- On peut d'une part utiliser un banc de filtres élémentaires, dans lequel on décompose la bande d'entrée en sous-bandes élémentaires et dans lequel on ne recombine que les sous bandes appartenant à la bande du filtre à réaliser. Les filtres élémentaires isolant les sous-bandes sont alors figés; la programmabilité étant assurée par le choix des sous-bandes à recombiner. Ces filtres élémentaires ont des spécifications de gabarit et de stabilité assez tendues : deux implantations sont envisageables : une qui utilise des filtres de type "OAS" (Ondes acoustiques de surface); l'autre qui utilise des filtres numériques. Mais une telle architecture "banc de filtres" n'est entièrement satifaisante que pour des applications particulières, puisque la programmation de la fréquence et de la bande du filtre réalisé ne peut se faire qu'avec un pas égal à la largeur d'une sous-bande. De plus, de grandes précautions doivent être apportées à la réalisation des filtres élémentaires : leur stabilité en fréquence et leur gabarit devant permettre d'assurer la continuité d'amplitude et de phase à la frontière des sous-bandes de manière à pouvoir effectuer la recombinaison finale dans les meilleures conditions. En outre la résolution on fréquence est limitée par le nombre de filtres élémentaires.
- On peut, d'autre part, considérer un filtre à gabarit programmable. Il existe deux types principaux de tels filtres programmables : les filtres à capacités commutées et les filtres numériques, qui, dans les deux cas, peuvent être réalisés avec des composants "VLSI" ("Very large scale integration") disponibles sur le marché. Les filtres à capacités commutées ne peuvent traiter que des signaux de fréquences inférieures à quelques dizaines de kilohertz. En ce qui concerne les filtres numériques à gabarit variable, les composants de type "VLSI" existant sur le marché sont en limite de la plage de fréquences recherchée. De plus, étant d'un emploi général, ils sont sur-dimensionnés dans la plupart des applications : en particulier en ce qui concerne la taille des mots numériques traités, ce qui entraîne un sur-coût de consommation préjudiciable à une application spatiale. Ces filtres numériques en "VLSI" intègrent un grand nombre de multiplieurs-accumulateurs qui sont eux-mêmes des fonctions complexes dont le bilan de fiabilité est critique ; l'architecture ne prévoyant pas de redondance interne, le résultat de fiabilité doit être amélioré par l'ajout de composants supplémentaires qui viennent dégrader le bilan de consommation du filtre. Par ailleurs chaque nouveau type de composant nécessite une qualification individuelle pour une application spatiale.

Il est connu de l'art antérieur par le document D1 =Claasen, T.A.C.M. et al., "Some considerations on the implementation of digital systems for signal processing", Philips Res. Repts, **30**, 73-84 (1975) un filtre numérique haut débit dans lequel chaque échantillon de sortie est obtenu en pondérant N échantillons d'entrée à l'aide de N coefficients $k_i$, chaque coefficient $k_i$ étant décomposé en un jeu de coordonnées dans lequel chacune des coordonnées correspond à p bits de ce coefficient $k_i$. Le document D1 décrit une méthode baptisée "RAC", acronyme pour ROM-accumulateur. Dans la méthode de D1, les multiplieurs d'un filtre classique sont remplacés par un dispositif mémoire (e.g. ROM) et un accumulateur. Les données d'entrée sont décomposées en une somme de n bits qui sont utilisés pour adresser une mémoire ROM et obtenir le résultat d'une multiplication stocké à cette adresse, évitant ainsi le besoin d'un dispositif de multiplication. Le mémoire ROM contient donc tous les résultats possibles des multiplications à effectuer, et les restitue en fonction de l'adressage par les signaux d'entrée du filtre. Cette réalisation a un inconvénient majeur en ce que la taille de mémoire ROM nécessaire augment de façon exponentielle avec le nombre de variables : $2^M$ mots de K bits, où K est déterminé par le nombre de bits nécessaires pour spécifier les paramètres du système, et M et le nombre de bits significatifs du signal à traiter.

Le document D2 = Kishis, G. et al., "A new realisation scheme of digital filters -- row-wise addition configuration", IEEE trans. on Acoustics. Speech and Signal Processing **v.25**(3) pp.256-257 (1972) décrit un filtre du même type, dans lequel un tableau des résultats de multiplications est stocké en mémoire ROM, et fourni aux moyens de sommation après pondération par un facteur multiplicatif qui peut prendre l'une des valeurs +1, 0, -1. L'innovation du document D2 est que les additions sont effectués selon une configuration en rangées, successivement après des décalages successives d'adresses mémoire. L'inconvénient de cette solution est la même que dans le document précédant.

Aucun composant connu n'étant susceptible de résoudre le problème posé, l'invention a pour objet de proposer une solution permettant de pallier les inconvénients énumérés ci-dessus.

Elle concerne en effet, un procédé de filtrage haut débit tel que décrit dans la revendication 1.

Elle propose également un dispositif de filtrage tel que décrit dans la revendication 2.

Dans une réalisation avantageuse ce dispositif comprend un ou plusieurs circuits identiques en technologie "ASIC" ("Application Specific Integration Circuit")

Un tel dispositif présente de nombreux avantages, et notamment :

- une vitesse de fonctionnement : l'usage d'une structure pipe-line permet, en effet, d'obtenir une vitesse de fonctionnement supérieure à celle des composants existants dans le commerce;
- Une optimisation de la taille de silicium : la capacité d'adaptation de l'architecture au besoin de l'utilisateur dans une implantation de type "ASIC" permet d'optimiser la consommation et l'encombrement : la taille d'un circuit de type "ASIC" étant réduite au strict nécessaire pour réaliser la fonction désirée. De plus la même quantité de silicium est utilisée, avec la même efficacité, pour réaliser différentes bandes de filtrage tout en conservant les caractéristiques d'ondulation, d'atténuation et de raideur des transitions du filtre;
- Une réutilisation d'un même concept et une adaptabilité au besoin : l'implantation en technologie "ASIC" de l'architecture proposée permet d'adapter le choix de la technologie aux besoins de l'utilisateur : technologie bipolaire pour augmenter la bande maximale de filtrage ; technologie "durcie" aux radiations pour les applications spatiales ; technologie CMOS pour une faible consommation;
- une amélioration des performances fréquentielles du filtre qui peut suivre l'évolution des technologies;
- Une structure modulaire utilisant des circuits "ASIC" identiques : ce qui a pour conséquence :

  - de permettre d'améliorer le bilan de fiabilité par l'adjonction de cellules de filtrage supplémentaires. Tous les circuits "ASIC" étant reprogrammables et identiques ; il est donc possible de remplacer n'importe lequel d'entre eux en décalant la programmation de la chaîne de filtrage et en utilisant un des circuits de redondance.
  - de permettre une réduction de coût par le développement d'un seul circuit "ASIC".

  - une qualification spatiale : l'utilisation du filtre dans le domaine spatial passe ici par la qualification d'une technologie "ASIC", ce qui offre des perspectives d'utilisation autres que la qualification d'un composant commercial spécifique au filtrage numérique.

Les caractéristiques et avantages de l'invention ressortiront d'ailleurs de la description qui va suivre, à titre d'exemple non limitatif, en référence aux figures annexées sur lesquelles :

- la figure 1 illustre une architecture de filtrage numérique connue;
- la figure 2 illustre le dispositif de l'invention;
- la figure 3 illustre une courbe de réponse d'une réalisation du dispositif de l'invention.

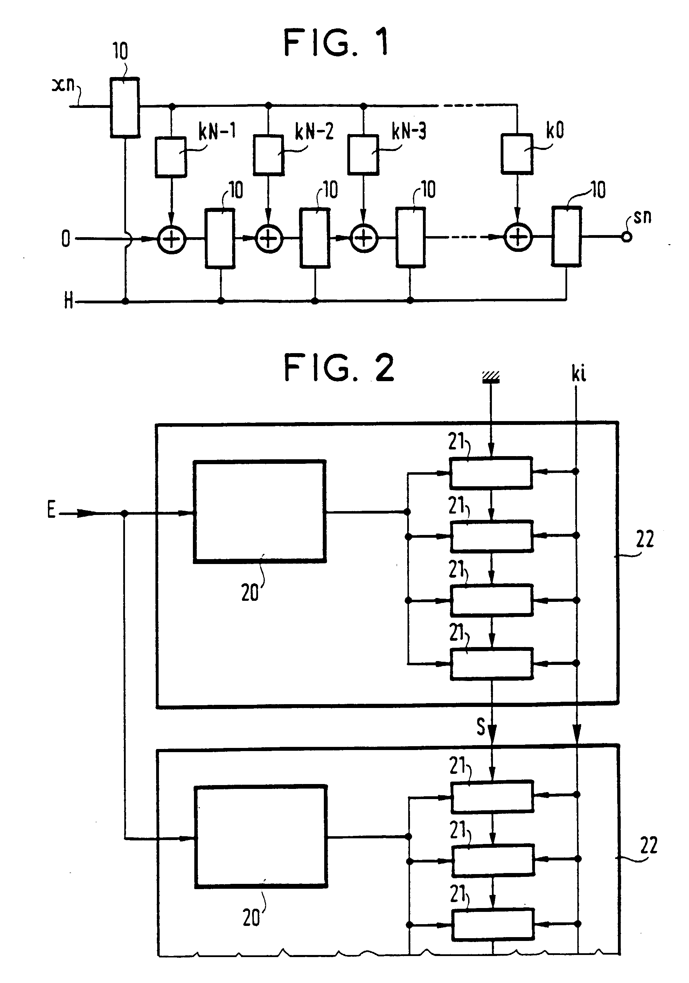

Le dispositif de filtrage de l'invention est de type filtre numérique "RIF" (à Réponse Impulsionnelle Finie), tel que représenté sur la figure 1, où chaque échantillon de sortie (sn) est obtenu en pondérant les N derniers échantillons d'entrée (xi) par un jeu de N coefficients (ki) définissant le filtre; en utilisant des bascules 10 synchronisées par une horloge H. On a ainsi :

$$sn = \sum_{i=0}^{i=N-1} ki.xn-i.$$

La structure d'implantation adaptée à l'algorithme de traitement est dite "Structure transposée" : la mémorisation des N échantillons d'entrée étant faite après pondération.

Pour utiliser un circuit de type "ASIC", l'algorithme de filtrage doit donc être implanté en utilisant les possibilités des bibliothèques des fondeurs et en minimisant le nombre de portes dans ce circuit. Dans cet esprit les multiplications sont éliminées du traitement et décomposées en opérations élémentaires simples : En effet soit la fonction multiplication n'existe pas chez tous les fondeurs soit la taille des mots n'est pas adaptée au besoin. Cette décomposition permet, en outre, la réutilisation de certaines opérations élémentaires communes à différents produits (réduction du nombre de portes).

Le principe de la décomposition de la multiplication par un coefficient ki est tel que chaque coefficient est décomposé en un jeu de coordonnées : ki =(ai, bi, ci, di,...) , dans lequel chacune des coordonnées correspond à p bits du coefficient ki. Ainsi à des coefficients ki codés sur 12 bits pour réaliser le dispositif de filtrage correspondent 12/p coordonnées. Pour un nombre N de coefficients, on obtient donc Nx12/p coordonnées, qui peuvent prendre toutes les valeurs comprises entre 0 et $2^P$-1.

Dans le dispositif de l'invention tel que représenté sur la figure 2, un pré-traitement (20) est effectué, dans chaque circuit "ASIC" 22, sur chaque échantillon (xn) : Il consiste à calculer systématiquement les $2^P$ produits du signal d'entrée xn par des entiers allant de 0 à $2^P$-1.

En pratique on se limite à p égal à 3 ou 4; ainsi les produits calculés sont utilisés presque surement par une des $Nx12/p$ coordonnées ( $2^p << 12.N/P$).

Le calcul des $2^p$ produits élémentaires s'obtient facilement pour les faibles valeurs de p, par décalages et additions relatives à la représentation binaire de l'échantillon d'entrée. La succession des calculs de ces produits est établie par un "arbre des calculs" qui optimise leur réutilisation (décalages-additions).

Un bloc 20 de pré-traitement commun à tous les produits est, donc, suivi de N blocs 21 de pondération accumulation. Chacun de ces blocs 21 effectue simplement la sommation des $12/p$ sorties du bloc 20 de pré-traitement puis les accumule au résultat du bloc 21 précédent. Ces sorties sont choisies en fonction de la valeur des coordonnées du coefficient considéré; chaque sortie étant décalée de p bits par rapport à la précédente avant sommation.

La programmation du dispositif de l'invention modifie le choix des sorties du bloc 20 de prétraitement par chargement de nouvelles valeurs de coordonnées dans le circuit "ASIC", lors de l'envoi d'un signal de télécommande. Le nombre de sorties du bloc de pré-traitement utilisées est un paramètre de dimensionnement du circuit "ASIC", il croît avec le nombre de bits des coefficients.

Dans le dispositif de l'invention on intègre, donc, dans un circuit "ASIC" un seul bloc de prétraitement 20 et autant de blocs de pondération 21 que possible. Plus la taille du circuit "ASIC" est importante, plus le prétraitement est rentabilisé car partagé entre un grand nombre de coefficients. Tous les circuits "ASIC" utilisés dans la réalisation du dispositif de l'invention sont identiques.

Une réalisation en technologie CMOS-SOS, bien adaptée aux contraintes spatiales en matière de radiations, a été effectuée. Dans un circuit 7000 portes il a été possible d'intégrer un bloc de prétraitement et trois blocs de pondération-accumulation pour des coefficients codés sur 12 bits et un signal d'entrée sur 8 bits. L'efficacité de l'algorithme est démontrée puisqu'il permet d'intégrer dans un composant l'équivalent de trois circuits "VLSI" (réalisant la multiplication-accumulation).

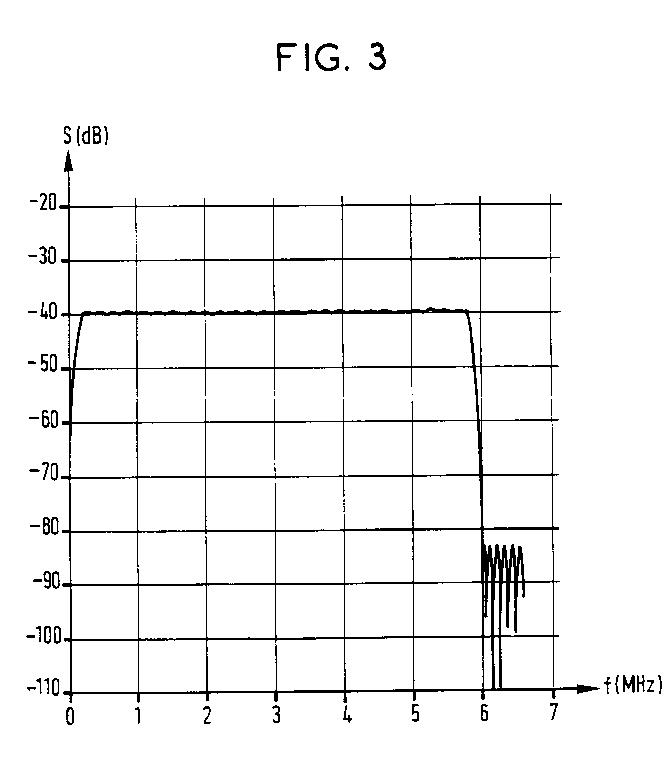

L'utilisation de 40 circuits "ASIC" identiques permet par exemple de réaliser toutes les bandes de filtrage comprises entre 400 KHz et 5.6 MHz, avec des caractéristiques identiques d'ondulation (± 0,35 dB) d'atténuation (40 dB) et de raideur de transitions (200 KHz). Ainsi la courbe, représentée sur la figure 3, correspond à une réponse en fréquence pour une bande de 5,6 MHz en utilisant 120 coefficients ki.

il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi :

. La bande maximale de filtrage étant limitée par le choix de la technologie du circuit "ASIC", il est possible d'utiliser le même schéma électrique dans une technologie bipolaire, ce qui permet de traiter des bandes supérieures.

. Il est possible d'intégrer dans chaque circuit "ASIC" une opération de sous-échantillonnage en sortie.

. Il est possible d'augmenter le degré d'intégration des circuits "ASIC", ce qui permet d'améliorer l'efficacité de l'algorithme puisque le bloc de pré-traitement peut être, alors, "amorti" sur un plus grand nombre de coefficients. En utilisant les résultats de la réalisation pré-citée on montre qu'il est possible d'intégrer 45 coefficients de 8 bits dans un circuit "ASIC" de 60000 portes.

. Il est possible, par une architecture fiable, d'isoler électroniquement et fonctionnellement une cellule défaillante afin de restituer les performances initiales.

**Revendications**

1. Procédé de filtrage haut débit dans lequel chaque échantillon de sortie sn est obtenu en pondérant N échantillons d'entrée xn à l'aide de N coefficients ki, où chaque coefficient ki est décomposé en un jeu de coordonnées : ki = (ai, bi, ci, di...) , dans lequel chacune des coordonnées correspond à p bits de ce coefficient ki; caractérisé en ce qu'un prétraitement, commun à tous les coefficients, est effectué sur chaque échantillon d'entrée xn le prétraitement consistant à calculer systématiquement les $2^p$ produits du signal d'entrée xn par les entiers allant de 0 à $2^p - 1$ ; et en ce qu'une pondération-accumulation est effectuée sur les signaux sortant du prétraitement pour chaque coefficient.

2. Dispositif de filtrage mettre en oeuvre le procédé selon la revendication 1, caractérisé en ce qu'il comprend un bloc (20) de prétraitement commun permettant de calculer systématiquement les $2^p$ produits du signal d'entrée xn par les entiers allant de 0 à $2^p-1$; et N blocs (21) de pondération-accumulation en série; chaque bloc (21) de pondération-accumulation effectuant la sommation de plusieurs sorties du bloc (20) de prétraitement, (ces sorties étant choisies en fonction de la valeur des coordonnées du coefficient considéré; chaque sortie étant décalée de p bits avant sommation; et accumulation avec la sortie du bloc précédent ; La programmabilité étant assurée par la possibilité de recharger un nouveau jeu de coordonnées par envoi d'un signal de télécommande.

3. Dispositif selon la revendication 2, caractérisé en ce qu'il comprend un ou plusieurs circuits (22) identiques mis en cascade, implantés dans des circuits de conception à la demande (ASIC...).

4. Dispositif selon la revendication 3, caractérisé en que, par une architecture fiable, il est possible d'isoler électroniquement et fonctionnellement une cellule défaillante afin de restituer les performances initiales.

**Patentansprüche**

1. Verfahren zur Filterung eines großen Durchsatzes, bei dem jede Ausgangstastprobe sn erhalten wird, indem N Eingangstastproben xn mit Hilfe von N Koeffizienten ki gewichtet werden, wobei jeder Koeffizient ki in einen Satz von Koordinaten ki = (ai, bi, ci, di, ...) zerlegt wird und jede der Koordinaten p Bits dieses Koeffizienten ki entspricht, dadurch gekennzeichnet, daß eine allen Koeffizienten gemeinsame Vorverarbeitung jeder Eingangstastprobe xn erfolgt, wobei die Vorverarbeitung darin besteht, systematisch die $2^P$ Produkte des Eingangssignals xn mit den ganzen Zahlen von 0 bis $2^P$-1 zu berechnen, und daß eine Gewichtung-Akkumulation der Signale erfolgt, die aus der Vorverarbeitung für jeden Koeffizienten herauskommen.

2. Filtervorrichtung, die das Verfahren nach Anspruch 1 anwenden kann, dadurch gekennzeichnet, daß sie einen Block (20) zur gemeinsamen Vorverarbeitung, der systematisch die $2^P$ Produkte eines Eingangssignals xn mit ganzen Zahlen von 0 bis $2^P$-1 berechnen kann, und N Blöcke (21) zur Gewichtung-Akkumulation in Reihe besitzt, wobei jeder Block (21) zur Gewichtung-Akkumulation eine Summierung mehrerer Ausgänge des Vorverarbeitungs-Blocks (20), die in Abhängigkeit vom Wert der Koordinaten des betreffenden Koeffizienten gewählt werden, wobei jeder Ausgang um p Bits vor der Summierung verschoben wird, und eine Akkumulation mit dem Ausgang des vorhergehenden Blocks durchführt, wobei die Programmierbarkeit gewährleistet wird durch die Möglichkeit, einen neuen Satz von Koordinaten durch ein Fernsteuerungssignal zu laden.

3. Vorrichtung nach Anspruch 2, dadurch gekennzeichnet, daß sie einen oder mehrere gleiche, in Kaskade angeordnete Schaltkreise (22) aufweist, die in auf speziellen Wunsch konzipierbare Schaltkreise (ASIC usw.) integriert sind.

4. Vorrichtung nach Anspruch 3, dadurch gekennzeichnet, daß durch eine zuverlässige Struktur eine fehlerhafte Zelle elektronisch und funktional isoliert werden kann, um die ursprünglichen Eigenschaften wiederherzustellen.

**Claims**

1. A high-throughput filtering method in which each output sample sn is obtained by weighting N input samples xn by means of N coefficients ki, where each coefficient ki is decomposed into a set of co-ordinates: ki = (ai, bi, ci, di, ...), in which set each of the co-ordinates corresponds to $\underline{p}$ bits of the coefficient ki; said method being characterized in that pre-processing common to all the coefficients is performed on each input sample, xn, the pre-processing consisting in calculating all of the $2^P$ products of the input signal xn multiplied by the integers in the range 0 to $2^P$-1; and in that weighting-and-adding is performed on the signals output from pre-processing for each coefficient.

2. Filtering apparatus suitable for performing the method according to claim 1, said apparatus being characterized in that it comprises both a common pre-processing block (20) making it possible to calculate all $2^P$ products of an input signal xn multiplied by the integers in the range 0 to $2^P$-1; and N weighting-and-adding blocks (21) in series; each weighting-and-adding block (21) firstly summing a plurality of outputs from the pre-processing block (20), the outputs being selected as a function of the value of the co-ordinates of the coefficient in question, each output being offset by $\underline{p}$ bits before being summed, and secondly adding in the output of the preceding block; programmability being provided by the possibility of reloading a new set of co-ordinates by sending a remote control signal.

3. Apparatus according to claim 2, characterized in that it comprises one or more identical circuits (22) disposed in cascade installed in custom-designed circuits (ASICs, etc.).

4. Apparatus according to claim 3, characterized in that, by using reliable architecture, it is possible to isolate a faulty cell electronically and operationally in order to restore initial performance levels.

# FIG. 1

# FIG. 2

# FIG. 3